# EUROPÄISCHE PATENTSCHRIFT

(11) **EP 1 539 418 B1**
(45) Veröffentlichungstag und Bekanntmachung des Hinweises auf die Patenterteilung: **02.08.2006**
(21) Anmeldenummer: 03737891.6
(22) Anmeldetag: 14.05.2003
(51) Int. Cl.: B23K 26/06, H05K 3/00

(54) **VERFAHREN UND VORRICHTUNG ZUR PUNKTUELLEN BEARBEITUNG EINES WERKSTÜCKS MITTELS LASERSTRAHLUNG**
METHOD AND DEVICE FOR THE PUNCTIFORM MACHINING OF A WORKPIECE BY MEANS OF A LASER BEAM
PROCEDE ET DISPOSITIF D'USINAGE PONCTUEL D'UNE PIECE PAR FAISCEAU LASER

(30) Priorität: 19.08.2002 DE 10237893
(43) Veröffentlichungstag der Anmeldung: 15.06.2005
(73) Patentinhaber: Hitachi Via Mechanics, Ltd., Ebina-Shi Kanagawa 243-0488 (JP)
(72) Erfinder: DIETRICH, Stefan, 76149 Karlsruhe (DE)
(74) Vertreter: Beetz & Partner
(86) Internationale Anmeldenummer: PCT/DE2003/001570
(87) Internationale Veröffentlichungsnummer: WO 2004/018142

(56) Entgegenhaltungen:
- DE-A- 4 009 859
- US-A1- 2002 000 426
- PATENT ABSTRACTS OF JAPAN vol. 2000, no. 10, 17. November 2000 (2000-11-17) & JP 2000 190087 A (SUMITOMO HEAVY IND LTD), 11. Juli 2000 (2000-07-11) in der Anmeldung erwähnt

## Beschreibung

Die Erfindung betrifft ein Verfahren und eine Vorrichtung zur punktuellen Bearbeitung eines Werkstückes mittels Laserstrahlung, wobei ein erster und mindestens ein zweiter Laserstrahl zeitlich versetzte Pulssequenzen liefern, die dann über Ablenkeinheiten jeweils zweidimensional auf vorgegebenen Zielpunkte gelenkt werden. Eine bevorzugte Anwendung betrifft das Bohren von Löchern in einer Leiterplatte.

Aus der EP 1020934A2 ist ein Laserbearbeitungsverfahren bekannt, bei dem Laserstrahlen von mehreren Laserquellen über eine Sammeloptik, beispielsweise über teildurchlässige Spiegel oder einen rotierenden Ablenkspiegel, zu einem kombinierten Strahl zusammengeführt und dann auf einen gemeinsamen Zielpunkt gelenkt werden. Auf diese Weise kann der Zielpunkt mit Laserstrahlen unterschiedlicher Eigenschaften gleichzeitig bearbeitet werden. Eine Fokussierung auf jeweils einen neuen Zielpunkt kann immer nur über die Ausgangsoptik für den gemeinsamen Strahl vorgenommen werden.

Aus der DE 4 009 859, die als nächstliegender Stand der Technik gesehen wird, sind ebenfalls ein Verfahren und eine Vorrichtung zur Erzeugung von Laserstrahlung hoher Leistung bekannt, wobei die Einzelstrahlen von mehreren Lasern in einer Sammeleinrichtung zu einem einzigen Ausgangsstrahl zusammengefaßt werden. Als Sammeleinrichtung können beispielsweise drehangetriebene Spiegel verwendet werden, die jeweils einen für einen Einzelstrahl bestimmten Reflexionsbereich besitzen, der sich immer nur über einen Teil des Rotationsbereiches erstreckt. Auch bei diesem Verfahren geht es darum, durch die Zusammenfassung der Einzelstrahlen einen kombinierten Strahl höherer Leistung zu erzeugen. Eine unabhängige Positionierung der Einzelstrahlen ist dabei nicht möglich.

Aus Patent Abstracts of Japan, Nr. 2000-190087 ist schließlich eine Laserbearbeitungsmaschine bekannt, bei der der Strahl eines Lasers über einen Polarisationsspiegel in zwei Strahlen aufgeteilt wird, welche dann über getrennte Ablenkeinheiten und über einen weiteren Polarisationsspiegel wieder zusammengeführt und über eine gemeinsame Linse auf das Werkstück gelenkt werden. Die dort verwendeten Polarisationsspiegel bedingen jedoch erhebliche Verluste der Laserstrahlen.

Ziel der vorliegenden Erfindung ist es, ein Verfahren und eine Vorrichtung zur punktuellen Bearbeitung eines Werkstücks mit Laserstrahlung anzugeben, wobei zwei oder mehr Laserstrahlen über eine möglichst einfache und raumsparende Optik auf ein gemeinsames Bearbeitungsfeld gelenkt werden können, um dort voneinander unabhängige Zielpunkte in möglichst schneller Abfolge zu bearbeiten.

Erfindungsgemäß wird dieses Ziel erreicht mit einem Verfahren, das folgende Schritte aufweist:
- ein erster und mindestens ein zweiter Laserstrahl liefern zeitlich versetzte Pulssequenzen;
- jeder Laserstrahl wird über eine eigene Ablenkeinheit zweidimensional auf einen jeweiligen Zielpunkt positioniert;
- die Laserstrahlen werden über mindestens eine rotierende Zerhackerscheibe mit lichtdurchlässigen und reflektierenden Segmenten zeitlich versetzt auf eine gemeinsame Abbildungseinheit und über diese auf ihre jeweiligen unterschiedlichen Zielpunkte gelenkt;
- die mindestens eine Zerhackerscheibe ist mit den Ablenkeinheiten derart synchronisiert, daß der erste Laserstrahl durch jeweils einen lichtdurchlässigen Bereich der mindestens einen Zerhackerscheibe auf die Abbildungseinheit fällt, während der zweite und gegebenenfalls jeder weitere Laserstrahl jeweils über ein reflektierendes Segment einer jeweiligen Zerhackerscheibe auf die Abbildungseinheit gelenkt wird, und
- wobei jeder Laserstrahl über seine zugehörige Ablenkeinheit jeweils dann auf einen neuen Zielpunkt positioniert wird, während ein anderer Laserstrahl seinen Zielpunkt bearbeitet.

Bei dem erfindungsgemäßen Verfahren werden zwei oder mehr Laserstrahlen über unabhängige Ablenkeinheiten, vorzugsweise Galvo-Spiegeleinheiten, auf ein gemeinsames Bearbeitungsfeld zusammengeführt, ohne daß die Ablenkeinheiten sich gegenseitig behindern. Die Zusammenführung erfolgt über drehbare Zerhackerspiegel verlustfrei auf ein gemeinsames Objektiv, vorzugsweise eine F-Theta-Linse, so daß die Strahlen jeweils senkrecht auf das Werkstück treffen. Durch die zeitlich versetzte Zusammenführung der einzelnen Laserstrahlen kann jeweils der eine Strahl über seine unabhängige Ablenkeinheit auf das neue Ziel positioniert werden, während ein anderer Strahl gerade seinen Zielpunkt bearbeitet. Dadurch läßt sich eine hohe Bearbeitungsgeschwindigkeit, insbesondere beim Bohren von Löchern in Leiterplatten, erzielen.

Je nach Art der verwendeten Laser und der erforderlichen Energie können die zusammengeführten Laserstrahlen von verschiedenen Lasern stammen. Es ist aber auch durchaus vorteilhaft, zunächst den Strahl eines einzigen Lasers mittels einer oder mehrerer Zerhackerscheiben in Einzelstrahlen aufzuteilen, diese über jeweils eigene Ablenkeinheiten zu führen und sie dann mit entsprechenden Zerhackerscheiben auf die gemeinsame Abbildungseinheit zusammenzuführen.

Eine erfindungsgemäße Vorrichtung zur punktuellen Bearbeitung eines Werkstückes weist folgende Merkmale auf:
- mindestens eine Laserquelle zur Erzeugung eines ersten und mindestens eines zweiten Laserstrahls mit jeweils zeitlich gegeneinander versetzten Impulsfolgen,
- eine erste Ablenkeinheit für den ersten Laserstrahl und eine zweite Ablenkeinheit für den zweiten Laserstrahl, wobei die beiden Laserstrahlen nach Durchlaufen der Ablenkeinheiten einen Winkel zueinander bilden,
- eine gemeinsame, den Ablenkeinheiten nachgeschaltete Abbildungseinheit,
- einen relativ zu der Abbildungseinheit positionierbaren Werkstückträger,
- eine erste drehbare Zerhackerscheibe mit lichtdurchlässigen und reflektierenden Segmenten, welche mit ihrer Reflexionsebene in der Winkelhalbierenden zwischen dem ersten und dem zweiten Laserstrahl derart angeordnet ist und mit der Steuerung der Laserquellen derart synchronisiert ist, daß der erste Laserstrahl jeweils durch ein lichtdurchlässiges Segment der Zerhackerscheibe direkt auf die Abbildungseinheit fällt und der zweite Laserstrahl durch ein reflektierendes Segment der Zerhackerscheibe auf die Abbildungseinheit gelenkt wird und
- wobei die Ablenkeinheiten derart mit der Zerhackerscheibe synchronisiert sind, daß jeweils ein Laserstrahl auf einen neuen Zielpunkt positioniert wird, während der andere Laserstrahl einen Zielpunkt bearbeitet.

Die Vorrichtung kann durch Einsatz zusätzlicher Ablenkeinheiten und Zerhackerscheiben auf die Zusammenführung von mehr als zwei Laserstrahlen erweitert werden, wobei diese Laserstrahlen jeweils von verschiedenen Laserquellen oder durch entsprechende Zerhackerscheiben aus einer einzigen Laserquelle gewonnen werden können.

In besonders vorteilhafter Ausgestaltung sind die lichtdurchlässigen und reflektierenden Segmente der Zerhackerscheibe bzw. Zerhackerscheiben jeweils in Abstimmung mit der Rotationsgeschwindigkeit der Zerhackerscheiben und mit der Wiederholfrequenz der jeweiligen Laserquelle so bemessen, daß alle für die Bearbeitung eines Zielpunktes (zum Beispiel Bohren eines Loches) erforderlichen Pulse über ein einziges Segment einer Zerhackerscheibe auf den Zielpunkt gelenkt werden. Somit kann mit jedem neuen Segment auch ein neuer Zielpunkt angesteuert werden.

Die Erfindung wird nachfolgend an Ausführungsbeispielen anhand der Zeichnung näher erläutert. Es zeigt
Figur 1 die schematische Darstellung einer erfindungsgemäßen Laserbearbeitungsvorrichtung,
Figur 2 eine Draufsicht auf eine in der Vorrichtung von Figur 1 verwendete Zerhackerscheibe,
Figur 3 eine abgewandelte Vorrichtung zur Laserbearbeitung mit drei aus einer einzigen Laserquelle gewonnenen Laserstrahlen und
Figur 4 eine Draufsicht auf zwei in Figur 3 verwendete Zerhackerscheiben.

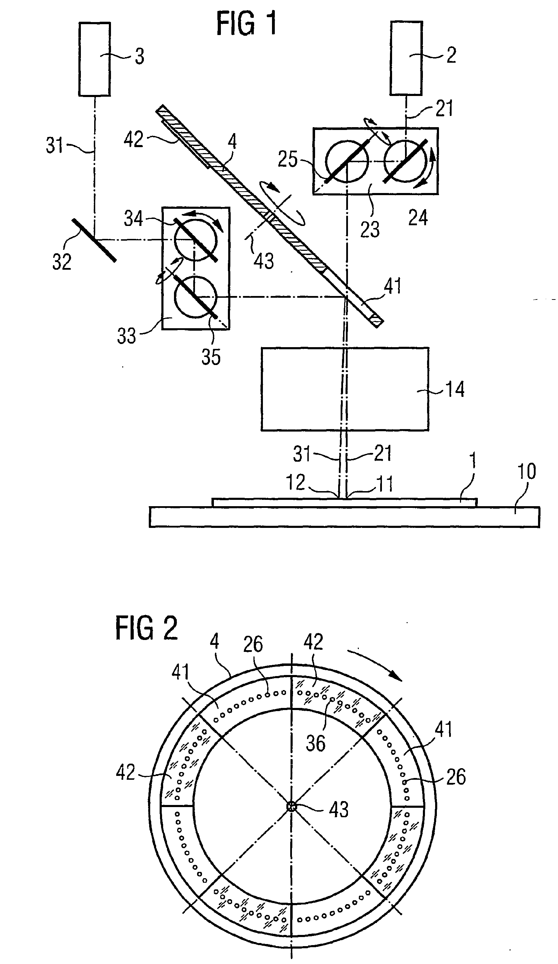

Die in Figur 1 gezeigte Laserbearbeitungsvorrichtung besitzt einen Werkstückträger 10, auf welchem ein Werkstück 1 angeordnet und fixiert ist. In an sich bekannter Weise kann der Werkstückträger 10 in mindestens zwei Richtungen (X-Richtung und Y-Richtung) verfahren werden, um das Werkstück 1 bzw. jeweils einen bestimmten Arbeitsbereich des Werkstücks in die richtige Bearbeitungsposition gegenüber einer Laserstrahlung zu bringen. Auch eine Relativbewegung in einer dritten Richtung (Z-Richtung) ist denkbar, um den Abstand und damit die Fokussierung gegenüber einer Laserstrahloptik zu verändern.

Um auf dem Werkstück 1 vorgegebene Zielpunkte 11 und 12 zu bearbeiten, vorzugsweise um Löcher zu bohren, sind in dem gezeigten Beispiel zwei Laserquellen 2 und 3 vorgesehen, deren Laserstrahlen 21 und 31 über eine erfindungsgemäße Optik zusammengeführt werden, um auf dem Werkstück die voneinander unabhängigen Zielpunkte 11 und 12 zu bearbeiten. Der Laserstrahl 21 wird über eine Ablenkeinheit 23 mit zwei Galvo-Spiegeln 24 und 25 nach zwei Richtungen abgelenkt, so daß er über eine Abbildungseinheit 14, vorzugsweise eine F-Theta-Linse, auf den vorgegebenen Zielpunkt 11 gelenkt wird.

Von einem zweiten Laser 3 wird ein Laserstrahl 31 über einen Umlenkspiegel 32 auf eine Ablenkeinheit 33 mit zwei Galvo-Spiegeln 34 und 35 und von dort über eine rotierende Zerhackerscheibe 4 mit dem Strahl 21 zusammengeführt und über die Abbildungseinheit 14 senkrecht auf den Zielpunkt 12 der Leiterplatte 1 gelenkt. Da die Ablenkeinheiten 23 und 33 unabhängig voneinander einstellbar sind, können die beiden Strahlen 21 und 31 auch unabhängig voneinander jeweils senkrecht zur Leiterplattenoberfläche auf ihre unterschiedlichen Zielpunkte 11 und 12 gerichtet werden.

Zur Zusammenführung der beiden Laserstrahlen 21 und 31 ist in der Winkelhalbierenden an der Stelle des Zusammentreffens beider Strahlen die drehbare Zerhackerscheibe 4 angeordnet; im Idealfall treffen die beiden Strahlen senkrecht aufeinander, so daß die Zerhackerscheibe mit ihrer Ebene unter 45° zu den beiden Strahlen steht.

Die Zerhackerscheibe 4 mit der Drehachse 43 besitzt, wie in Figur 2 gezeigt ist, abwechselnd lichtdurchlässige Segmente 41 und reflektierende Segmente 42. Dabei ist die Umdrehungszahl der Zerhackerscheibe 4 mit den Güteschaltern der beiden Laser 2 und 3 so synchronisiert, daß jeweils die Laserstrahlen 21 ungebrochen durch ein lichtdurchlässiges Segment 41 der Zerhackerscheibe 4 unmittelbar zur Linse 14 gelenkt werden, während die Laserstrahlen 31 des Lasers 3 jeweils auf ein reflektierendes Segment 42 treffen und von dort in die gleiche Richtung wie die Laserstrahlen 21 auf die Linse 14 gelenkt werden. Die Segmente 41 und 42 der Zerhackerscheibe sind jeweils so bemessen, daß alle Pulse 26 bzw. 36 eines Laserstrahls 21 bzw. 31, die für die Bearbeitung eines Zielpunktes, also zum Beispiel für das Bohren eines Loches am Zielpunkt 11 bzw. 12, erforderlich sind, durch ein einziges Segment 41 passieren bzw. von einem einzigen Segment 42 abgelenkt werden, so daß jeweils nach Durchlaufen eines solchen Segmentes das betreffende Ziel voll bearbeitet ist. Wenn beispielsweise alle Impulse 26 des Laserstrahls 21, die für das Bohren eines Loches am Zielpunkt 11 erforderlich sind, durch das betreffende Segment 41 gegangen sind, ist an dem Zielpunkt 11 ein Loch fertiggebohrt. Während dann beim Weiterdrehen der Zerhackerscheibe 4 der Laserstrahl 31 auf ein Segment 42 trifft und alle Pulse 36 einer Sequenz des Laserstrahls 32 über das Segment 42 auf den Zielpunkt 12 gelenkt werden, um dort das nächste Loch zu bohren, kann der Strahlengang des Laserstrahls 21 über die Ablenkeinheit 23 bereits auf ein weiteres Ziel positioniert werden, so daß für das Positionieren der jeweiligen Laserstrahlen auf ein neues Ziel keine Zeit verloren geht.

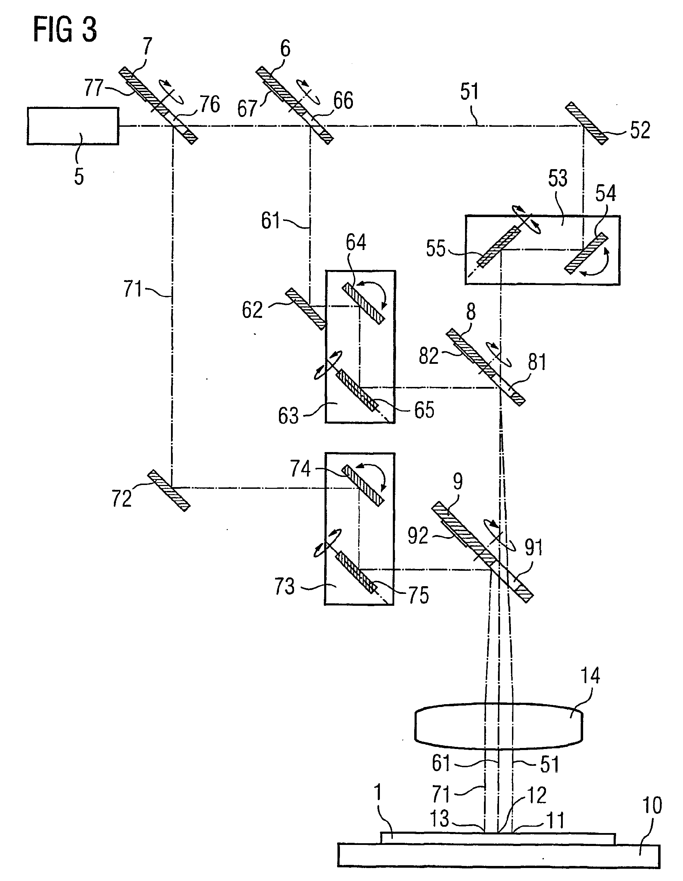

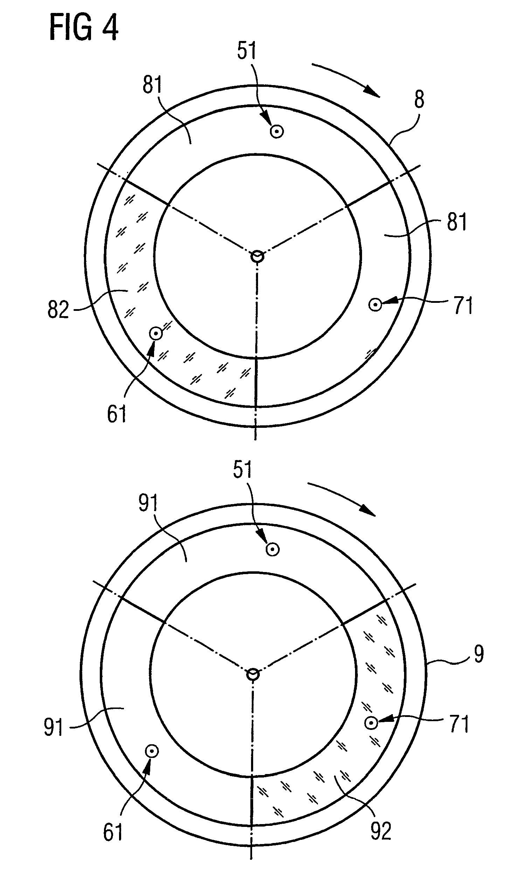

In Figur 3 ist eine etwas abgewandelte Ausführungsform der Anordnung von Figur 1 gezeigt. In diesem Fall ist lediglich beispielshalber ein einziger Laser 5 vorgesehen, dessen Strahl über Zerhackerscheiben 6 und 7 aufgeteilt wird. Diese Zerhackerscheiben 6 und 7 sind mit lichtdurchlässigen und reflektierenden Segmenten versehen, so daß je nach Winkelstellung der beiden Zerhackerscheiben ein erster Laserstrahl 51, ein zweiter Laserstrahl 61 und ein dritter Laserstrahl 71 erzeugt werden. Die Verteilung der lichtdurchlässigen Segmente 66 bzw. 76 und der reflektierenden Segmente 67 und 77 ist ähnlich wie bei den später noch beschriebenen Zerhackerscheiben 8 und 9 mit ihren lichtdurchlässigen Segmenten 81 und 91 sowie den reflektierenden Segmenten 82 und 92, wie sie in Figur 4 dargestellt sind.

Der durch lichtdurchlässige Segmente 66 und 76 der beiden Zerhackerscheiben 6 und 7 gehende erste Laserstrahl 51 wird über einen Umlenkspiegel 52 auf eine Ablenkeinheit 53 mit Galvo-Spiegeln 54 und 55 gelenkt, mit denen er auf einen vorgegebenen Zielpunkt 11 positioniert werden kann. Im optischen Pfad zwischen der Ablenkeinheit 53 und der Linse 14 sind zwei drehbare Zerhackerscheiben jeweils unter einem Winkel von 45° angeordnet, die wie die Zerhackerscheibe 4 lichtdurchlässige und reflektierende Segmente 81 und 82 bzw. 91 und 92 aufweisen. Wenn beide Zerhackerscheiben 8 und 9 jeweils ein lichtdurchlässiges Segment 81 bzw. 91 im Strahlengang des Laserstrahls 51 aufweisen, kann also dieser Laserstrahl 51 über die Linse 14 auf den Zielpunkt 11 gelangen.

Trifft der Ausgangsstrahl des Lasers 5 in der Zerhackerscheibe 7 auf ein lichtdurchlässiges Segment 76 und an der Zerhackerscheibe 6 auf ein reflektierendes Segment 67, so wird ein Laserstrahl 61 erzeugt, der über einen Umlenkspiegel 62 einer Ablenkeinheit 63 mit zwei Galvo-Spiegeln 64 und 65 zugeführt wird. Dort wird er auf die Position eines zweiten Zielpunktes 12 eingestellt. Die Zerhackerscheiben 8 und 9 sind wie die Zerhackerscheiben 6 und 7 so synchronisiert, daß der Laserstrahl 61 an der Zerhackerscheibe 8 auf ein reflektierendes Segment 82 und dann an der Zerhackerscheibe 9 auf ein lichtdurchlässiges Segment 91 trifft, so daß er über die Linse 14 dem Zielpunkt 12 zugeführt werden kann.

In vergleichbarer Weise wird dann, wenn die Zerhackerscheibe 7 dem Ausgangsstrahl des Lasers 5 ein reflektierendes Segment 77 zuwendet, ein Laserstrahl 71 gebildet und über den Umlenkspiegel 72 einer Ablenkeinheit 73 mit den Galvo-Spiegeln 74 und 75 zugeführt. Über diese Ablenkeinheit 73 kann der Laserstrahl 71 bereits zu der Zeit, wenn der Laserstrahl 51 oder der Strahl 61 auf ihren zugehörigen Zielpunkt 11 oder 12 treffen, auf einen neuen Zielpunkt 13 voreingestellt werden. Wenn dann die Zerhackerscheiben 6, 7, 8 und 9 eine Winkelstellung einnehmen, bei der der Laserstrahl 71 gebildet wird und über die Ablenkeinheit 73 auf ein reflektierendes Segment 92 der Zerhackerscheibe 9 trifft, wird er auf die voreingestellte Position zum Zielpunkt 13 auf der Leiterplatte 1 gelenkt.

Der Aufbau der Zerhackerscheiben 8 und 9, der auch dem der Zerhackerscheiben 6 und 7 entspricht, ist in Figur 4 skizziert. Entsprechend den vorgesehenen drei Laserstrahlen, die zusammengeführt werden sollen, weisen die Zerhackerscheiben jeweils drei Segmente auf, und zwar jeweils zwei lichtdurchlässige Segmente 81 bzw. 91 und ein reflektierendes Segment 82 bzw. 92. Die reflektierenden Segmente sind gegeneinander so versetzt, daß nacheinander die Laserstrahlen 51, 61 und 71 zur Linse 14 und zu den Zielpunkten 11, 12 und 13 gelenkt werden. In Figur 4 sind die beiden Zerhackerscheiben 8 und 9 übereinander in gleicher Phase dargestellt. Wenn also die beiden in der Figur jeweils oben liegenden lichtdurchlässigen Segmente 81 und 91 im Strahlengang des Laserstrahls 51 übereinander liegen, wird dieser Strahl 51 bis zur Linse 14 durchgelassen. Wenn in der Zerhackerscheibe 8 ein reflektierendes Segment 82 im Strahlengang liegt und darunter die Zerhackerscheibe 9 ein lichtdurchlässiges Segment 91 im Strahlengang aufweist, wird der Strahl 61 durchgelassen, und wenn die Zerhackerscheibe 8 ein lichtdurchlässiges Segment 81 über einem reflektierenden Segment 92 der Zerhackerscheibe 9 aufweist, wird lediglich der Laserstrahl 71 zur Linse 14 und zum Werkstück durchgeleitet. Wie bereits erwähnt, sind die Zerhackerscheiben 8 und 9 mit den Zerhackerscheiben 6 und 7 synchronisiert, so daß jeweils der gleiche Laserstrahl 51, 61 oder 71 zu einem bestimmten Zeitpunkt mit einer bestimmten Zahl von Pulsen vom Laser 5 zu der betreffenden Ablenkeinheit und von der betreffenden Ablenkeinheit zum Werkstück durchgelassen wird.

Natürlich ist die Zahl der auf diese Weise zusammenführbaren Laserstrahlen nicht auf die gezeigten Ausführungsbeispiele beschränkt. Auch können die Segmente in den Ablenkscheiben jeweils ein Vielfaches der Zahl der verwendeten Laserstrahlen betragen.

## Patentansprüche

1. Verfahren zur punktuellen Bearbeitung eines Werkstückes (1) mittels Laserstrahlung mit folgenden Schritten:
- ein erster und mindestens ein zweiter Laserstrahl (21,31;51,61,71) liefern zeitlich versetzte Pulssequenzen (26; 36);
- jeder Laserstrahl (21,31;51,61,71) wird über eine eigene Ablenkeinheit (23,33;53,63,73) zweidimensional auf einen jeweiligen Zielpunkt (11,12,13) positioniert;
- die Laserstrahlen (21,31;51,61,71) werden über mindestens eine rotierende Zerhackerscheibe (4;8,9) mit lichtdurchlässigen (41;81,91) und reflektierenden (42;82,92) Segmenten zeitlich versetzt auf eine gemeinsame Abbildungseinheit (14) und über diese auf ihre jeweiligen unterschiedlichen Zielpunkte (11, 12, 13) gelenkt;
- **dadurch gekennzeichnet, dass** die mindestens eine Zerhackerscheibe (4;8,9) mit den Ablenkeinheiten (23, 33; 53, 63, 73) derart synchronisiert ist, daß der erste Laserstrahl (21;51) durch jeweils ein lichtdurchlässiges Segment (41;81,91) der mindestens einen Zerhackerscheibe (4;8,9) auf die Abbildungseinheit (14) fällt, während der zweite und gegebenenfalls jeder weitere Laserstrahl (31;61,71) jeweils über ein reflektierendes Segment (42;82,92) einer jeweiligen Zerhackerscheibe (4;8,9) auf die Abbildungseinheit 14 gelenkt wird und
- **dass** jeder Laserstrahl (21,31;51,61,71) über seine zugehörige Ablenkeinheit (23, 33; 53, 63, 73) jeweils dann auf einen neuen Zielpunkt (11,12,13) positioniert wird, während ein anderer Laserstrahl (21, 31; 51, 61, 71) seinen Zielpunkt (11,12,13) bearbeitet.

2. Verfahren nach Anspruch 1 mit folgenden Schritten:
- jeder Laserstrahl (21,31;51,61,71) liefert für die Bearbeitung eines Zielpunktes (11,12,13) eine vorgegebene Anzahl von Pulsen (26,36) und
- die Steuerung der jeweiligen Laserstrahlen (21,31;51,61,71) ist derart mit der Steuerung der Zerhackerscheiben (4;8,9) synchronisiert, daß jeweils alle für einen Zielpunkt bestimmten Pulse (26;36) eines Laserstrahls (21,31;51,61,71) während des Durchlaufs eines Segmentes (41,42;81,82;91,92) der Zerhackerscheibe (4) bzw. der Zerhackerscheiben (8,9) zum Zielpunkt (11,12,13) gelangen.

3. Verfahren nach Anspruch 1 oder 2, wobei jeder Laserstrahl (21,31) von einem eigenen Laser (2,3) erzeugt wird.

4. Verfahren nach Anspruch 1 oder 2, wobei ein von einem einzigen Laser (5) erzeugter Strahl durch eine oder mehrere Zerhackerscheiben (6,7) mit lichtdurchlässigen (61,71) und reflektierenden (62,72) Segmenten in getrennte Laserstrahlen (51,61,71) mit zeitlich versetzten Pulsfolgen unterteilt wird, welche dann getrennt jeweils einer Ablenkeinheit (53,63,73) zugeführt werden.

5. Vorrichtung zur punktuellen Bearbeitung eines Werkstückes mittels Laserstrahlung nach einem Verfahren gemäß einem der Ansprüche 1 bis 4, mit folgenden Merkmalen:
- mindestens einer Laserquelle (2,3;5) zur Erzeugung eines ersten und mindestens eines zweiten Laserstrahls (21,31;51,61,71) mit jeweils zeitlich gegeneinander versetzten Impulsfolgen (26,36),
- einer ersten Ablenkeinheit (23;53) für den ersten Laserstrahl (21;51) und einer zweiten Ablenkeinheit (33;639 für den zweiten Laserstrahl (31;61), wobei die beiden Laserstrahlen nach Durchlaufen der Ablenkeinheiten (23,33;53,63) einen Winkel zueinander bilden,
- einer gemeinsamen, den Ablenkeinheiten nachgeschalteten Abbildungseinheit (14),
- einem relativ zu der Abbildungseinheit (14) positionierbaren Werkstückträger (10),
- einer ersten drehbaren Zerhackerscheibe (4;8) mit lichtdurchlässigen (41;81) und reflektierenden (42;82) Segmenten, welche mit ihrer Reflexionsebene in der Winkelhalbierenden zwischen dem ersten (21;51) und dem zweiten (31;61) Laserstrahl derart angeordnet und mit der Steuerung der Laserquelle (5) bzw. Laserquellen (2,3) derart synchronisiert ist, daß der erste Laserstrahl (21;51) jeweils durch ein lichtdurchlässiges Segment (41;81) der Zerhackerscheibe (4;8)direkt auf die Abbildungseinheit (14) fällt und der zweite Laserstrahl (31;61) durch ein reflektierendes Segment (42;82) der Zerhackerscheibe (4;8) auf die Abbildungseinheit (14) gelenkt wird und
- **dadurch gekennzeichnet, dass** die Ablenkeinheiten (23, 33; 53, 63) derart mit der Zerhackerscheibe (4;8) synchronisiert sind, daß jeweils ein Laserstrahl (21,31;51,61) auf einen neuen Zielpunkt (11,12,13) positioniert wird, während der andere Laserstrahl (21;31;51,61) einen Zielpunkt (11,12,13) bearbeitet.

6. Vorrichtung nach Anspruch 5 mit folgenden zusätzlichen Merkmalen:
- eine Laserquelle (5) ist zur Erzeugung mindestens eines weiteren Laserstrahls (71) vorgesehen,
- für jeden weiteren Laserstrahl (71) ist eine weitere Ablenkeinheit (73) vorgesehen, an deren Ausgang der weitere Laserstrahl (71) im Winkel zum ersten Laserstrahl (51) steht,
- jeder weiteren Ablenkeinheit (73) ist eine weitere Zerhackerscheibe (9) mit lichtdurchlässigen (91) und reflektierenden (92) Segmenten nachgeschaltet, deren Reflexionsebene in der Winkelhalbierenden zwischen dem ersten und dem weiteren Laserstrahl liegt und
- die Laserquelle (5), die Ablenkeinheiten (53,63,73) und die Zerhackerscheiben (8,9) sind so synchronisiert, daß jeweils nur ein Laserstrahl (51,61,71) über die Abbildungseinheit (14) auf einen Zielpunkt (11,12,13) zur Bearbeitung gelenkt wird, während die Ablenkeinheiten (53,63,73) für die anderen Laserstrahlen (51,61,71) auf einen neuen Zielpunkt positioniert werden.

7. Vorrichtung nach Anspruch 5 oder 6, wobei für jeden Laserstrahl (21,31) eine eigene Laserquelle (2,3) vorgesehen ist.

8. Vorrichtung nach Anspruch 5 oder 6, wobei eine gemeinsame Laserquelle (5) vorgesehen ist, welcher mindestens eine Zerhackerscheibe (6,7) mit lichtdurchlässigen (61,71) und reflektierenden (62,72) Segmenten nachgeschaltet ist, um einen ersten (51) und mindestens einen zweiten Laserstrahl (61,71) voneinander zu trennen und jeweils auf eine eigene Ablenkeinheit (53,63) zu lenken.

9. Vorrichtung nach einem der Ansprüche 5 bis 8, wobei bei jeder Zerhackerscheibe (4;8,9) die Größe der Segmente (41,42;81,82;91,92) und die Drehgeschwindigkeit so bemessen sind, daß jeweils alle für die Bearbeitung eines Zielpunktes (11,12,13) auf dem Werkstück bestimmten Pulse (26;36) über ein einziges Segment (41,42;81,82;91,92) auf die Abbildungseinheit gelenkt werden.

## Claims

1. A method and device for the punctiform machining of a workpiece (1) by means of a laser beam, comprising the following steps:
- a first and at least a second laser beam (21, 31; 51, 61, 71) supply temporally offset pulse sequences (26; 36);
- each laser beam (21, 31; 51, 61, 71) is positioned two-dimensionally on a respective target point (11, 12, 13) via an intrinsic deviation unit (23, 33; 53, 63, 73);
- the laser beams (21, 31; 51, 61, 71) are deflected via at least one rotating chopper disk (4; 8, 9) having light-permeable (41; 81, 91) and reflecting (42; 82, 92) segments in a temporally offset manner to a common imaging unit (14) and via the same to their respective different target points (11, 12, 13);
- **characterized in that** said at least one chopper disk (4; 8, 9) is synchronized with said deviation units (23, 33; 53, 63, 73) such that said first laser beam (21; 51) respectively impinges through a light-permeable segment (41; 81, 91) of said at least one chopper disk (4; 8, 9) onto said imaging unit (14), while said second and optionally each further laser beam (31; 61, 71) is respectively deflected to said deviation unit (14) via a reflecting segment (42; 82, 92) of a respective chopper disk (4; 8, 9), and
- **that** each laser beam (21, 31; 51, 61, 71) is respectively positioned on a new target point (11, 12, 13) via its associated deviation unit (23, 33; 53, 63, 71) while another laser beam (21, 31; 51, 61, 71) machines its target point (11, 12, 13).

2. The method according to claim 1, comprising the following steps:
- each laser beam (21, 31; 51, 61, 71) supplies a predetermined number of pulses (26, 36) for the machining of a target point (11, 12, 13), and
- the control of said respective laser beams (21, 31; 51, 61, 71) is synchronized with the control of said chopper disk (4; 8, 9) such that all pulses (26; 36) of one laser beam (21, 31; 51, 61, 71) determined for a target point respectively reach the target point (11, 12, 13) during the cycle of a segment (41, 42; 81, 82; 91, 92) of said chopper disk (4) and said chopper disks (8, 9), respectively.

3. The method according to claim 1 or 2, wherein each laser beam (21, 31) is generated by an intrinsic laser (2, 3).

4. The method according to claim 1 or 2, wherein a beam generated by a single laser (5) is divided by one or a plurality of chopper disks (6, 7) having light-permeable (61, 71) and reflecting (62, 72) segments into separated laser beams (51, 61, 71) having temporally offset pulse sequences which are then separately supplied to a respective deviation unit (53, 63, 73).

5. A device for the punctiform machining of a workpiece by means of a laser beam according to a method according to any one of claims 1 to 3, comprising the following features:
- at least one laser source (2, 3; 5) for generating a first and at least a second laser beam (21, 31; 51, 61, 71) having respective pulse sequences (26, 36) temporally offset to each other,
- a first deviation unit (23; 53) for said first laser beam (21; 51) and a second deviation unit (33; 63) for said second laser beam (31; 61), said two laser beams forming an angle with each other after passing through said deviation units (23, 33; 53, 63),
- a common imaging unit (14) downstream of said deviation units,
- a workpiece carrier (10) positionable relative to said imaging unit (14),
- a first rotatable chopper disk (4; 8) having light-permeable (41; 81) and reflecting (42; 82) segments, which is disposed with its plane of reflection in the bisecting line of the angle between said first (21; 51) and said second (31; 61) laser beam and synchronized with the control of said laser source (5) and said laser sources (2, 3), respectively, such that said first laser beam (21; 51) respectively impinges directly onto said imaging unit (14) through a light-permeable segment (41; 81) of said chopper disk (4; 8) and said second laser beam (31; 61) is directed to said imaging unit (14) through a reflecting segment (42; 82) of said chopper disk (4; 8), and
- **characterized in that** said deviation units (23, 33; 53, 63) are synchronized with said chopper disk (4; 8) such that one respective laser beam (21, 31; 51, 61) is positioned to a new target point (11, 12, 13) while the other laser beam (21, 31; 51, 61) machines a target point (11, 12, 13).

6. The device according to claim 5, comprising the following additional features:
- a laser source (5) is provided for generating at least one further laser beam (71),
- for each further laser beam (71) a further deviation unit (73) is provided at the output of which said further laser beam (71) is positioned at an angle to said first laser beam (51),
- downstream of each further deviation unit (73) a further chopper disk (9) having light-permeable (91) and reflecting (92) segments is connected, the plane of reflection of which is disposed in the bisecting line of the angle between said first and said further laser beam, and
- said laser source (5), said deviation units (53, 63, 73) and said chopper disks (8, 9) are synchronized such that one laser beam (51, 61, 71) only is respectively deflected to a target point (11, 12, 13) for machining via said imaging unit (14) while said deviation units (53, 63, 73) for said other laser beams (51, 61, 71) are positioned to a new target point.

7. The device according to claim 5 or 6, wherein for each laser beam (21, 31) an intrinsic laser source (2, 3) is provided.

8. The device according to claim 5 or 6, wherein a common laser source (5) is provided downstream of which at least a chopper disk (6, 7) having light-permeable (61, 71) and reflecting (62, 72) segments is connected to separate a first (51) and at least a second laser beam (61, 71) and respectively direct them to an intrinsic deviation unit (53, 63).

9. The device according to any one of claims 5 to 8, wherein in each chopper disk (4; 8, 9) the size of the segments (41, 42; 81, 82; 91, 92) and the rotational speed are dimensioned such that all pulses (26; 36) respectively determined for machining a target point (11, 12, 13) on said workpiece are deflected to said imaging unit via a single segment (41, 41; 81, 82; 91, 92).

## Revendications

1. Procédé d'usinage ponctuel d'une pièce (1) au moyen d'un faisceau laser comprenant les étapes suivantes :
- un premier et au moins un deuxième faisceau laser (21, 31 ; 51, 61, 71) émettent des séquences d'impulsions décalées dans le temps (26 ; 36) ;
- chaque faisceau laser (21, 31 ; 51, 61, 71) est positionné en deux dimensions sur un point cible respectif (11, 12, 13) par l'intermédiaire de sa propre unité de déviation (23, 33 ; 53, 63, 73) ;
- les faisceaux lasers (21, 31 ; 51, 61, 71) sont déviés de manière décalée dans le temps, par le biais d'au moins un disque interrupteur périodique rotatif (4 ; 8, 9) comportant des segments perméables à la lumière (41 ; 81, 91) et des segments réfléchissants (42 ; 82, 92), sur une unité de réflexion commune (14) et sont dirigés par le biais de celle-ci sur leurs divers points cibles respectifs (11, 12, 13) ;
**caractérisé en ce qu'**
au moins un disque interrupteur périodique (4 ; 8, 9) est synchronisé avec les unités de déviation (23, 33 ; 53, 63, 73) de telle sorte que le premier faisceau laser (21 ; 51) soit incident sur l'unité de réflexion (14) en passant à chaque fois par un segment perméable à la lumière (41 ; 81, 91) du (au moins un) disque interrupteur périodique (4 ; 8, 9), alors que le deuxième et le cas échéant tout autre faisceau laser supplémentaire (31 ; 61, 71) est/sont dirigé(s) respectivement par le biais d'un segment réfléchissant (42 ; 82, 92) d'un disque interrupteur périodique respectif (4 ; 8, 9) sur l'unité de réflexion (14) et
- **que** chaque faisceau laser (21, 31 ; 51, 61, 71) est alors positionné sur un nouveau point cible (11, 12, 13) par le biais de l'unité de déviation qui lui est associée (23, 33 ; 53, 63, 73) respectivement, alors qu'un autre faisceau laser (21, 31 ; 51, 61, 71) usine son point cible (11, 12, 13).

2. Procédé selon la revendication 1 comprenant les étapes suivantes :
- chaque faisceau laser (21, 31 ; 51, 61, 71) émet pour l'usinage d'un point cible (11, 12, 13) un nombre déterminé à l'avance d'impulsions (26, 36) et
- la commande des faisceaux lasers respectifs (21, 31 ; 51, 61, 71) est synchronisée avec la commande des disques interrupteurs périodiques (4 ; 8, 9) de telle sorte que respectivement toutes les impulsions (26, 36) d'un faisceau laser (21, 31 ; 51, 61, 71) destinées à un point cible parviennent au point cible (11, 12, 13) au cours de la traversée d'un segment (41, 42 ; 81, 82 ; 91, 92) du disque interrupteur périodique (4) ou des disques interrupteurs périodiques (8, 9).

3. Procédé selon la revendication 1 ou 2, où chaque faisceau laser (21, 31) est produit par son propre laser (2, 3).

4. Procédé selon la revendication 1 ou 2 dans lequel un faisceau produit par un seul laser (5) est divisé par un ou plusieurs disques interrupteurs périodiques (6, 7) comportant des segments perméables à la lumière (61, 71) et des segments réfléchissants (62, 72), en faisceaux lasers séparés (51, 61, 71) avec des trains d'impulsions décalés dans le temps, qui sont ensuite amenés chacun séparément à une unité de déviation (53, 63, 73).

5. Dispositif d'usinage ponctuel d'une pièce par irradiation laser d'après un procédé selon l'une des revendications 1 à 4 ayant les caractéristiques suivantes :
- au moins une source laser (2, 3 ; 5) pour produire un premier et au moins un deuxième faisceau laser (21, 31 ; 51, 61, 71) avec des trains d'impulsions respectivement décalés dans le temps l'un par rapport à l'autre (26, 36) ;
- une première unité de déviation (23 ; 53) pour le premier faisceau laser (21 ; 51) et une deuxième unité de déviation (33 ; 63) pour le deuxième faisceau laser (31 ; 61), où les deux faisceaux lasers forment un angle l'un par rapport à l'autre après le passage par les unités de déviation (23, 33 ; 53, 63),
- une unité de réflexion commune (14), montée en série après les unités de déviation,
- un porte - pièce à usiner (10) positionnable par rapport à l'unité de réflexion (14),
- un premier disque interrupteur périodique rotatif (4 ; 8) ayant des segments perméables à la lumière (41, 81) et des segments réfléchissants (42 ; 82), disposé avec son plan de réflexion à la moitié de l'angle formé entre le premier (21 ; 51) et le deuxième (31 ; 61) faisceau laser et synchronisé avec la commande de la source laser (5) ou des sources lasers (2, 3) de telle sorte que le premier faisceau laser (21 ; 51) soit directement incident sur l'unité de réflexion (14) en passant à chaque fois par un segment perméable à la lumière (41 ; 81) du disque interrupteur périodique (4 ; 8) et que le deuxième faisceau laser (31 ; 61) soit dirigé sur l'unité de réflexion (14) en passant par un segment réfléchissant (42 ; 82) du disque interrupteur périodique (4 ; 8) et
**caractérisé en ce que**
- les unités de déviation (23, 33 ; 53, 63) sont ainsi synchronisées avec le disque interrupteur périodique (4 ; 8), qu'un faisceau laser (21, 31 ; 51, 61) est respectivement positionné sur un nouveau point cible (11, 12, 13) alors que l'autre faisceau laser (21, 31 ; 51, 61) usine un point cible (11, 12, 13).

6. Dispositif selon la revendication 5, ayant les caractéristiques supplémentaires suivantes :
- une source laser (5) est prévue pour la production d'au moins un autre faisceau laser (71),
- pour chaque autre faisceau laser (71), on prévoit une autre unité de déviation (73), à la sortie de laquelle l'autre faisceau laser (71) décrit un angle avec le premier faisceau laser (51),
- chaque autre unité de déviation (73) est montée en série après un autre disque interrupteur rotatif (9) avec des segments perméables à la lumière (91) et des segments réfléchissants (92) dont le plan de réflexion se situe à la moitié de l'angle formé entre le premier et le deuxième faisceau laser et
- la source laser (5), les unités de déviation (53, 63, 73) et les disques interrupteurs périodiques (8, 9) sont synchronisés de sorte que respectivement seulement un faisceau laser (51, 61, 71) est dirigé sur un point cible (11, 12, 13) pour l'usinage par le biais de l'unité de réflexion (14), alors que les unités de déviation (53, 63, 73) sont positionnées sur un nouveau point cible pour d'autres faisceaux lasers (51, 61, 71).

7. Dispositif selon la revendication 5 ou 6, dans lequel, pour chaque faisceau laser (21, 31), sa propre source laser (2, 3) est prévue.

8. Dispositif selon la revendication 5 ou 6, dans lequel l'on prévoit une source laser commune (5) qui est montée en série après au moins un disque interrupteur périodique (6, 7) comportant des segments perméables à la lumière (61, 71) et des segments réfléchissants (62, 72) pour séparer un premier (51) faisceau laser et au moins un deuxième faisceau laser (61, 71) et pour les diriger respectivement sur leur propre unité de déviation (53, 63).

9. Dispositif selon l'une des revendications 5 à 8, dans lequel, pour chaque disque interrupteur périodique (4 ; 8, 9), la taille des segments (41, 42 ; 81, 82 ; 91, 92) et la vitesse de rotation sont dimensionnées de sorte que respectivement toutes les impulsions (26 ; 36) destinées à l'usinage d'un point cible (11, 12, 13) sur la pièce à usiner sont dirigées par le biais d'un seul segment (41, 42; 81, 82 ; 91, 92) sur l'unité de réflexion.
